# EUROPEAN PATENT APPLICATION

(11) **EP 4 810 978 A1**
(43) Date of publication of application: **23.09.2026**
(21) Application number: 25305361.5
(22) Date of filing: 17.03.2025
(51) Int. Cl.: G01R 33/035, G01R 29/26, G01R 33/02

(54) **MULTI-MODAL MEASUREMENT DEVICE FOR MEASURING PHYSICAL PARAMETERS OF A CRYOGENIC ENVIRONMENT**

(71) Applicant: Alice & Bob, 75015 Paris (FR)
(72) Inventor: STEVENS, Jeremy, 75015 Paris (FR); GÜMÜS, Efe, 75015 Paris (FR)
(74) Representative: Atout PI Laplace

(57) **Abstract**

The invention relates to a multi-modal measurement device (1) for measuring physical parameters of a cryogenic environment, comprising:
- a resonator (3) including a capacitive element (13) having a capacitance, and a flux-sensitive inductive element (15) having a variable inductance, said resonator (3) having a tunable resonant frequency depending on said capacitance and variable inductance;
- a flux line (5) inductively coupled to the flux-sensitive inductive element (15);
- a DC source (7) arranged to supply said flux line (5) with electric current for generating a magnetic flux through the flux-sensitive inductive element (15), said magnetic flux varying the inductance of the flux-sensitive inductive element (15);
- a transmission line (9) coupled to the resonator (3);
- an electromagnetic radiation source (11) arranged to deliver electromagnetic radiation via said transmission line (9); and
- a processing unit.

## Description

The field of the invention relates to in-situ measurement of parameters of a cryostat setup.

Superconducting circuits used in quantum experiments are highly sensitive and require precise diagnostic tools to monitor their performance, especially when operating in a cryogenic environment. These circuits, typically cooled to milli-Kelvin temperatures in a cryostat, are subject to various sources of noise and interference, which can compromise the stability and coherence of the qubits. Consequently, accurately measuring and characterizing the performance of superconducting circuits, as well as the cryogenic setup that supports them, is crucial for advancing quantum technologies.

A major source of noise in these circuits is flux noise, which arises from fluctuations in magnetic fields that affect the circuit's performance. Techniques for measuring flux noise, such as those using flux qubits, have been proposed in the literature, including methods that assume a 1/f noise spectrum, see for instance F. Yoshikara et al. Decoherence of Flux Qubits due to 1/f Flux Noise (Phys. Rev. Lett. 97, 167001, 2006). However, this assumption does not always hold, and as a result, these methods are limited to providing only a snapshot of the noise spectrum at a specific frequency, rather than a comprehensive understanding.

More sophisticated methods, like the use of CPMG ("Carr-Purcell-Meiboom-Gill") pulse sequences, to change the frequency spectrum over which the circuit is sensitive, offer broader frequency coverage but are experimentally demanding and still fail to measure flux noise effectively in the mHz to kHz range, see for instance J. Bylander et al. "Noise spectroscopy through dynamical decoupling with a superconducting flux qubit" (Nature Physics 7, 565-570, 2011).

Furthermore, simpler techniques using anharmonic resonators - with multiple SQUID loops - can reduce experimental complexity. As an example, a time trace of the circuit's frequency response is sufficient in S. Günzler *et al. "Superconducting microwave magnetometer for absolute flux detection"* (arXiv:2107.05929) to achieve a noise spectrum. However, the anharmonicity of the resonator results in low signal-to-noise ratio (SNR), slow measurement speeds, and an inability to reach kHz frequencies, making it inadequate for precise and fast flux noise characterization. Moreover, such solutions involve a 3D resonator, which complicates scaling and prevents integration with other functionalities.

These limitations highlight the need for more efficient, scalable, and versatile techniques to measure flux noise across a wider range of frequencies.

In addition to flux noise, line attenuation is another critical parameter for superconducting circuits, as signal loss between the room temperature electronics and the cryogenic setup can degrade the overall performance. Existing methods for measuring line attenuation, such as those that use transmon qubits and readout resonators, are effective but require a qubit, see for instance J. Gambetta et al. "Qubit-photon interactions in a cavity: Measurement-induced dephasing and number splitting" (Phys. Rev. A 74, 042318, 2006).

Line temperature is another key parameter that influences qubit decoherence. Temperature fluctuations in the control lines can contribute to unwanted interactions with the qubit, leading to increased decoherence rates. Techniques for measuring line temperature, often based on transmon qubits, can provide some insight into the thermal environment, but they are limited in their ability to identify and quantify the specific environmental modes that contribute most significantly to decoherence, see for instance M. Scigliuzzo et al. "Primary thermometry of propagating microwaves in the quantum regime" (arXiv:2003.13522), or D.S. Lvov et al. "Thermometry Based on a Superconducting Qubit" (arXiv:2409.02784). These methods tend to focus on the frequency range where the qubit is most sensitive, but they do not provide a comprehensive picture of the overall temperature profile of the system.

Finally, the quantum efficiency of a detector measures how closely it approaches the quantum limit of information extraction. In superconducting circuits, a qubit's state is read out via a microwave pulse processed by an amplification chain and a digitizer. While this process encodes information in the pulse, it also induces dephasing. Quantum efficiency is defined as the ratio between the extracted information rate and the induced dephasing rate. A precise evaluation of the quantum efficiency is essential for optimizing readout fidelity and diagnosing noise sources in the amplification chain. Methods using transmon qubits have been proposed to measure this parameter, see for instance C.C. Bultink et al. "General method for extracting the quantum efficiency of dispersive qubit readout in circuit QED" (arXiv:1711.05336), or P. Campagne-Ibarcq "Quantum backaction and feedback in superconducting circuits" (2015).

Although significant progress has been made in the measurement of flux noise, line attenuation, line temperature, and quantum efficiency, existing methods still have important limitations. Many techniques require specialized components or are dependent on specific assumptions that limit their applicability in real-world experiments. Moreover, existing methods often require multiple devices or sequential measurements, which introduces inefficiencies in terms of experimental volume and time. There is a need for a more efficient, scalable, and integrated diagnostic system capable of simultaneously measuring these key parameters with minimal complexity.

The present invention seeks to improve the situation.

To this end, the Applicant proposes a multi-modal measurement device for measuring physical parameters of a cryogenic environment. The multi-modal measurement device comprises:
- a resonator including a capacitive element having a capacitance, and a flux-sensitive inductive element having a variable inductance, the resonator having a tunable resonant frequency depending on the capacitance and variable inductance;
- a flux line inductively coupled to the flux-sensitive inductive element;
- a DC source arranged to supply the flux line with electric current for generating a magnetic flux through the flux-sensitive inductive element, the magnetic flux varying the inductance of the flux-sensitive inductive element;
- a transmission line coupled to the resonator;
- an electromagnetic radiation source arranged to deliver electromagnetic radiation via the transmission line; and
- a processing unit.

The multi-modal measurement device is configured to operate at least in:
- a flux noise measurement mode in which the DC source supplies the flux line with electrical current for generating a magnetic flux varying the inductance of the flux-sensitive inductive element to tune the resonant frequency of the resonator to reach a desired operating point, the electromagnetic radiation source delivers electromagnetic radiation via the transmission line to the resonator for measuring a time evolution of the resonant frequency of the resonator at the desired operating point, and the processing unit determines flux noise based on the time evolution of the resonant frequency of the resonator, and
- at least one other physical parameter measurement mode in which the electromagnetic radiation source (11) delivers electromagnetic radiation via the transmission line (9) to the resonator (3) or another resonator (25) coupled to the transmission line (9) for acquiring a response signal from the resonator (3) or the other resonator (25), and the processing unit determines the physical parameter based on the signal, the physical parameter being distinct from flux noise.

According to one or more embodiments, the capacitive element is a 2D capacitor.

According to one or more embodiments, the resonator, the flux line and the transmission line are made from a 2D dielectric substrate on which a layer of superconducting material is deposited.

According to one or more embodiments, the capacitance of the capacitive element is less than 1 picofarad.

According to one or more embodiments, the resonator exhibits anharmonicity below 10 MHz, preferably below 1 MHz.

According to one or more embodiments, the flux-sensitive inductive element includes one or more DC superconducting quantum interference devices, DC SQUIDs, in series, preferably three or more DC SQUIDs in series.

According to one or more embodiments, in the flux noise measurement mode, the desired operating point is in the vicinity of the operating point at which the derivative of the resonant frequency of the resonator with respect to the magnetic flux is maximal in absolute value.

According to one or more embodiments, in the flux noise measurement mode, the time evolution of the resonant frequency of the resonator is measured by spectroscopy.

According to one or more embodiments, the multi-modal measurement device is further configured to operate in a line attenuation measurement mode in which the electromagnetic radiation source delivers electromagnetic radiation via the transmission line to the resonator for measuring reflection coefficients of the resonator, and the processing unit determines an attenuation value of the transmission line based on the reflection coefficients.

According to one or more embodiments, the electromagnetic radiation source is arranged to deliver electromagnetic radiation having controllable amplitude and frequency, and, in the line attenuation measurement mode, the amplitude of the electromagnetic radiation source is successively set to each amplitude value of a set of amplitude values, and, for each of the amplitude values, a plurality of reflection coefficients are measured, each by delivering, from the electromagnetic radiation source, electromagnetic radiation having a respective frequency to the resonator via the transmission line.

According to one or more embodiments, the multi-modal measurement device further comprises a measurement circuit coupled to the transmission line, the measurement circuit including a readout resonator and a transmon.

According to one or more embodiments, the multi-modal measurement device further comprises a transmon capacitively coupled to the transmission line.

Other features and advantages of the invention will become apparent from the following description provided for indicative and non-limiting purposes, with reference to the accompanying drawings, wherein:
- Figure 1 illustrates the multi-modal measurement device according to the invention,
- Figure 2 illustrates the resonator of the multi-modal measurement device of Figure 1,
- Figure 3 illustrates the inductive element of the resonator of Figure 2,
- Figure 4 illustrates the resonant frequency of the resonator as a function of the voltage of the DC source,
- Figure 5 illustrates the frequency response of the resonator in the flux noise measurement mode,
- Figure 6 illustrates the real and imaginary parts of the reflection coefficients in the line attenuation measurement,
- Figure 7 illustrates an embodiment in which the multi-modal measurement device comprises a readout resonator and transmon,
- Figure 8 illustrates an embodiment in which the multi-modal measurement device comprises another readout resonator and another transmon, as well as an additional transmon capacitively coupled to the transmission line,
- Figure 9 illustrates the amplitude of Ramsey fringes as a function of the amplitude of the electromagnetic radiation source,
- Figure 10 illustrates the signal-to-noise ratio as a function of the amplitude of the electromagnetic radiation source, and
- Figure 11 illustrates the dephasing rate as a function of the detuning.

The drawings and the following description are comprised for the most part of positive and well-defined features. As a result, they are not only useful in understanding the invention, but they can also be used to contribute to its definition, should the need arise.

### A. The multi-modal measurement device

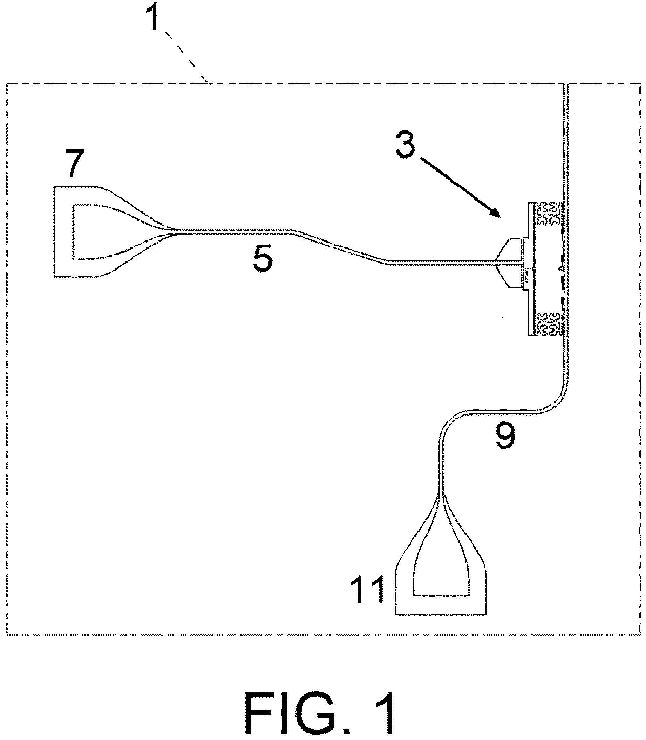

Figure 1 illustrates a multi-modal measurement device 1.

The multi-modal measurement device 1 is designed as a chip that can be plugged into a cryostat setup to measure and characterize the performance of this setup and predict its impact on other superconducting circuits housed within.

### A.1. Applications of the measurement device

The multi-modal measurement device 1 can be used with various cryostat setups, including cryogenic detectors such as transition-edge sensor (TES), microwave kinetic inductance detector (MKID), superconducting tunnel junction (STJ), superconducting nanowire single-photon detector (SNSPD), micro- or nano- calorimeter and bolometer, hot electron bolometer (HEB), etc. It is also compatible with multiple qubit designs, including transmon qubit, fluxonium qubit, spin qubit, charge qubit, as well as bosonic code qubits such as cat qubits or GKP qubits, etc.

So far, the Applicant's work has been generally concerned with the stabilization of cat qubits.

In the embodiment of Figure 1, the multi-modal measurement device 1 comprises a resonator 3, a flux line 5, a DC source 7, a transmission line 9, and an electromagnetic radiation source 11.

It should be noted that, in Figure 1, the reference sign "7" actually shows the connector of the flux line 5, which allows the flux line 5 to be connected to the DC source. However, for the sake of simplicity, it is assumed hereinafter that the connector of the flux line 5 is connected to the DC source, and the reference sign "7" is used to designate the DC source.

Similarly, the reference sign "11" actually represents the connector of the transmission line 9, which allows the transmission line 9 to be connected to the electromagnetic radiation source 11. However, for the sake of simplicity, it is assumed hereinafter that the connector of the transmission line 9 is connected to the electromagnetic radiation source, and the reference sign "11" is used to designate the electromagnetic radiation source.

The multi-modal measurement device 1 also comprises a processor and a memory (not shown in Figure 1).

### A.2. The resonator

The resonator 3 is involved in the various measurements performed by the multi-modal measurement device 1. Specifically, the respective values of several parameters of the cryostat setup can be computed based on the frequency response of the resonator 3.

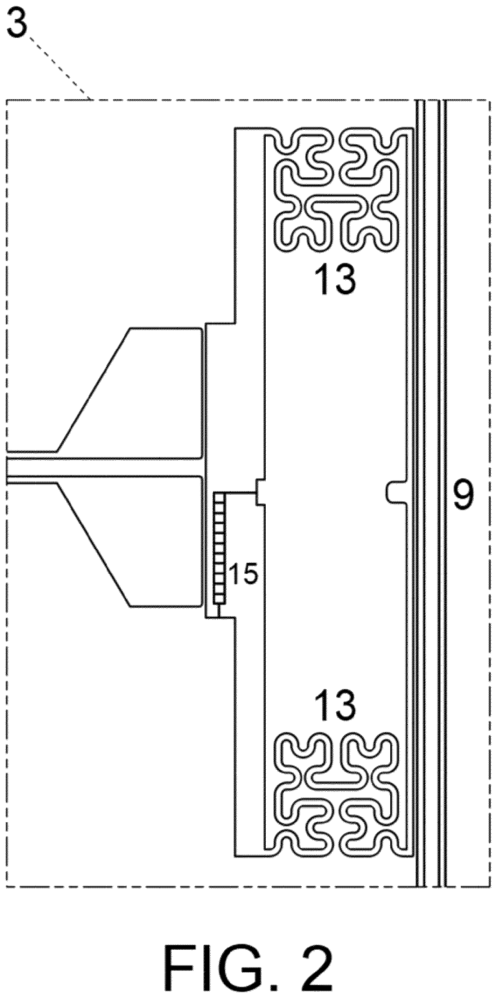

Figure 2 is a zoomed-in view of Figure 1, providing a more detailed illustration of the resonator 3.

As shown in Figure 2, the resonator 3 includes a capacitive element 13 and an inductive element 15. The resonator 3 can thus be referred to as an LC circuit.

The capacitive element 13 and the inductive element 15 can be described as being either in series or in parallel. In any case, it is known that the resonant frequency of such a resonator 3 depends on the capacitance of the capacitive element 13 and the inductance of the inductive element 15: $f = \frac{1}{\sqrt{LC}}$ where: - *C* is the capacitance of the capacitive element 13, and
- *L* is the inductance of the inductive element 15.

In particular, the Applicant's work has led them to use a capacitive element 13 with a high capacitance *C*. Typically, the capacitance *C* is less than 1 picofarad (pF). In the example of Figures 1 and 2, the capacitance *C* of the capacitive element 13 is approximately 300-400 femtofarads (fF). Moreover, the capacitance *C* is typically greater than or equal to 0.1 pF.

Advantageously, the capacitive element 13 is a 2D capacitor. A 2D design makes the capacitive element 13 easy to fabricate and facilitates the integration of the multi-modal measurement device 1 into a cryostat setup.

In the example of Figures 1 and 2, the capacitive element 13 has a "fractal" design which increases capacitance while maintaining a compact surface area.

The resonator 3 is made from a 2D dielectric substrate on which a superconducting material layer is deposited.

The dielectric substrate is for example silicon or sapphire. Of course, other materials may be considered for the dielectric substrate. The superconducting material is for example aluminum (Al), tantalum (Ta) or niobium (Nb), and more generally all conventional superconducting metals.

The capacitive element 13 is manufactured by etching the superconducting material layer so as to isolate two fractal regions within the superconducting material layer. Such fractal regions are each delimited by a perimeter groove.

As an example, the perimeter groove has a constant width all around the fractal regions. Such a width is typically equal to 10 micrometers (µm). At the perimeter groove, each fractal region and the surrounding superconducting material layer, which forms a ground plane, face each other and are therefore separated by the aforementioned width, thereby together defining the capacitive element 13. Each fractal region and the surrounding superconducting material layer lie in the same plane. Such a capacitive element 13 can thus be described as a coplanar capacitor.

In the fractal design, increasing the length of the perimeter groove, and therefore the perimeter of each fractal region, makes it possible to increase the capacitance *C* of the capacitive element 13. Consequently, the length of the perimeter groove is adjusted so that the capacitance *C* of the capacitive element 13 is as high as desired.

The fractal design maximizes the capacitance *C* of the capacitive element 13 while minimizing the dimensions of its footprint on the superconducting material layer. In addition, such a design has the advantage of reducing the concentration of electric fields and therefore reducing loss channels such as dielectric losses. It also minimizes the self-inductance of the capacitive element 13 so that there is no resonating mode within the capacitive element 13 at low frequency.

Furthermore, in the example of Figures 1 and 2, the capacitive element 13 is formed with two distinct fractal regions, providing a form of symmetry to the resonator 3. However, the capacitive element 13 could be formed from a single fractal region.

Other 2D designs can be used to manufacture the capacitive element 13.

The capacitive element 13 can be manufactured using standard fabrication techniques thanks to its 2D design. Despite the high capacitance *C* of the capacitive element 13, the resonator 3 will still show some anharmonicity. As detailed below, this anharmonicity can be mitigated through the design of the inductive element 15.

The inductive element 15 is unique in that its inductance is variable and can therefore be adjusted. Such a variable inductance makes it possible to tune the resonant frequency of the resonator 3.

Specifically, the inductive element 15 is flux-sensitive. In other words, the inductance of the inductive element 15 varies depending on the magnetic flux through it.

In the example of Figures 1 and 2, the inductive element 15 is a chain of DC superconducting quantum interference devices, i.e. several DC superconducting quantum interference devices in series.

A Superconducting QUantum Interference Device (SQUID) is a superconducting loop containing at least one Josephson junction. The SQUID exploits the properties of the Josephson junction, i.e. two superconductors connected through a small insulating junction or layer between which supercurrent tunneling can occur.

There are two types of SQUID: the DC SQUID, which contains two Josephson junctions in parallel; and the RF SQUID, which contains a single Josephson junction and is generally coupled to an LC circuit with an alternating current source of radio frequency.

Details of the SQUID, including the equations that govern its behavior, can be found, *inter alia,* in the article by A. Kraft et al., "Superconducting Quantum Interference Device (SQUID)" (UBC Physics 502 Project (2017 Fall)).

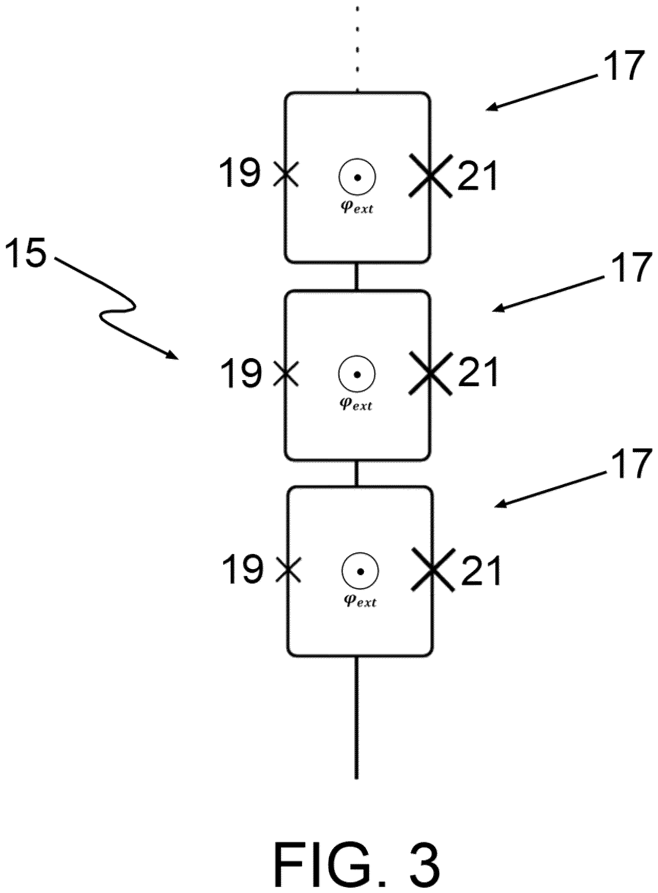

Figure 3 shows a possible design for realizing the inductive element 15. The inductive element 15 is a chain of DC SQUIDs 17.

Each DC SQUID 17 is a superconducting loop containing a Josephson junction 19 and a Josephson junction 21 in parallel.

Moreover, each DC SQUID 17 is asymmetric. In other words, the Josephson junction 19 and the Josephson junction 21 have different Josephson energies - also known as "tunneling energy". This is to ensure a resonant frequency tunability of the resonator 3 compatible with the experimental setup. Equivalently, the Josephson junction 19 and the Josephson junction 21 have different Josephson inductances. It can also be stated that the Josephson junction 19 and the Josephson junction 21 are different.

The design shown in Figure 3 with asymmetric DC SQUIDs 17 is preferable to avoid problems which may arise due to diverging frequency response for symmetric DC SQUIDs, but it is still possible to implement the inductive element 15 using symmetric DC SQUIDs 17 In other words, the Josephson junction 19 and the Josephson junction 21 have the same Josephson energy. Equivalently, the Josephson junction 19 and the Josephson junction 21 have the same Josephson inductance. It can also be stated that the Josephson junction 19 and the Josephson junction 21 are identical.

In Figure 3, the reduced magnetic flux applied to each DC SQUID 17 is conventionally indicated by the reference sign *φₑₓₜ.*

The inductive element 15 can be implemented according to designs other than the one shown in Figure 3. For example, the inductive element 15 can include a chain of DC SQUIDs and a chain of Josephson junctions. In other words, the inductive element 15 includes several DC SQUIDs arranged successively in series and several Josephson junctions arranged successively in series. Alternatively, the inductive element 15 includes DC SQUIDs and Josephson junctions connected in series alternately. It is also possible to implement the inductive element 15, partially or entirely, using materials with a high kinetic inductance like granular aluminium (Al) or niobium-titanium-nitride (NbTiN), for example.

The DC SQUIDs 17 in series reduce the anharmonicity of the resonator 3. More specifically, the anharmonicity induced by the capacitive element 13 is multiplied by a factor inversely proportional to the number of DC SQUIDs 17. The resonator 3 is a weakly anharmonic resonator.

The synergy between the designed capacitance of the capacitive element 13 and the DC SQUIDs 17 of the inductive element 15 allows for lower anharmonicity without the need for large, impractical capacitors like MEMS capacitors, which are difficult to fabricate. By optimizing this combination, we reduce the Kerr nonlinearity of the resonator, improving the signal-to-noise ratio (SNR) in flux noise measurements. This improvement enables higher power operation, shorter integration periods, and a broader frequency band, increasing the measurement's sensitivity and accuracy.

Other flux-sensitive devices can be used instead of or in addition to the DC SQUIDs 17 in a chain to reduce the anharmonicity of the resonator 3. For example, one or more RF SQUIDs and/or one or more SNAILs can be used.

A Superconducting Non-linear Asymmetric Inductive element (SNAIL) is a superconducting loop containing a single Josephson junction and at least one chain of Josephson junctions.

The SNAIL was first described by N. E. Frattini et al. in the article "3-Wave Mixing Josephson Dipole Element" (arxiv: 1702.00869), where it is above all described as a dipole circuit element with third-order nonlinearity for implementing three-wave mixing. This article defines the SNAIL as a superconducting loop of *n* large Josephson junctions - corresponding here to the at least one chain of Josephson junctions - and a single smaller Josephson junction - corresponding here to the single Josephson junction.

For example, one or more flux-sensitive devices can each be an Asymmetrically Threaded Superconducting Quantum Interference Device (ATS), which can be considered as a DC SQUID shunted by an inductor, the latter possibly being formed from an array of Josephson junctions. Any number of variations of the above flux-sensitive devices can be conceived.

As explained above, a plurality of such flux-sensitive devices in series is particularly advantageous so as to thereby form the inductive element 15 whilst providing a lower anharmonicity to the resonator 3.

Typically, the anharmonicity of the resonator 3 is less than 10 MHz, and preferably less than 1 MHz. In the example of Figures 1 and 2, the anharmonicity of the resonator 3 is approximately 450 kHz. The anharmonicity corresponds to the fourth-order Kerr coefficient, also known as Kerr nonlinearity. Such values ensure that the Kerr nonlinearity of the resonator 3 is significantly weaker than the coupling to the transmission line 9.

The skilled person knows different methods for measuring the Kerr nonlinearity, for example N. Bartolo et al. "Exact steady state of a Kerr resonator with one-and two-photon driving and dissipation: Controllable Wigner-function multimodality and dissipative phase transitions" (Physical Review A 94.3 (2016): 033841); P. Campagne-Ibarcq et al. "Quantum error correction of a qubit encoded in grid states of an oscillator" (https://arxiv.org/pdf/1907.12487.pdf); G. Kirchmair et al. "Observation of quantum state collapse and revival due to the single-photon Kerr effect" (Nature 495.7440 (2013): 205-209 (https://arxiv.org/abs/1211.2228)); A. Essig et al. "Multiplexed photon number measurement" (https://arxiv.org/pdf/2001.03217.pdf); and R. W. Heeres et al. "Cavity State Manipulation Using Photon-Number Selective Phase Gates" (https://arxiv.org/pdf/1503.01496.pdf).

### A.3. Control ports

Referring to Figure 1, the flux line 5 is inductively coupled to the inductive element 15.

The flux line 5 is capable of carrying an electric current, which flows all along the flux line 5 from the DC source 7 to the resonator 3.

Consequently, the flux line 5 is configured to generate a magnetic flux through the inductive element 15. More particularly, the flux line 5 generates such a magnetic flux through the inductive element 15 when the flux line 5 is traversed by an electric current. This magnetic flux varies the inductance of the inductive element 15.

In view of the foregoing, it appears that the resonant frequency of the resonator 3 depends on the inductance of the inductive element 15, i.e. the magnetic flux through the inductive element 15.

As detailed below, the dependence of the resonant frequency of the resonator 3 on magnetic flux is exploited to measure flux noise.

The DC source 7 is arranged to supply the flux line 5 with electric current.

As detailed above, the electric current flowing along the flux line 5 results in the generation of a magnetic flux through the inductive element 15. It is therefore possible, by setting the intensity of the electric current, to modulate the inductance of the inductive element 15.

The DC source 7 can be a current source. In this case, the intensity of the electric current is directly controlled at the DC source 7.

Alternatively, the DC source 7 can be a voltage source. The DC source 7 is coupled to a resistive element, such as a resistor, which converts the voltage applied by the DC source 7 into an electric current. In this case, the intensity of the electric current is indirectly controlled at the DC source 7 by adjusting the voltage applied to the resistive element.

in the example of Figures 1 and 2, the transmission line 9 is capacitively coupled to the resonator 3. Alternatively, the transmission line 9 can be inductively coupled to the resonator 3.

The transmission line 9 is capable of carrying electromagnetic radiation, which propagates all along the transmission line 9 from the electromagnetic radiation source 11 to the resonator 3.

The electromagnetic radiation source 11 is arranged to deliver electromagnetic radiation at a chosen frequency to the resonator 3 via the transmission line 9.

The electromagnetic radiation source 11 is typically a microwave radiation source.

Typically, the microwave radiation source can be realized using a digital-to-analog converter to directly generate microwave frequencies.

Alternatively, the microwave radiation source can be realized using a source emitting electromagnetic radiation in a wavelength range other than microwaves, such as an optical light source, provided that a spectral down-conversion is performed to convert the electromagnetic radiation into microwaves.

The amplitude and the frequency of the electromagnetic radiation delivered by the electromagnetic radiation source 11 can both be controlled.

The electromagnetic radiation sources, such as the electromagnetic radiation source 11, are very common in superconducting circuits. As mentioned above, the Applicant mainly works with cat qubits, and the various known stabilization schemes require drives and pumps which are electromagnetic radiation sources:
For example, the parametric dissipative stabilization, with jump operator *L*₂ = $\sqrt{{κ}_{2}} \left({a}^{2}-{α}^{2}\right)$, where *κ*₂ is the two-photon dissipation rate, *a* is the photon annihilation operator of the memory mode a and *α* is a complex number characterizing the cat qubit, requires electromagnetic radiation sources to be implemented.

This jump operator is realized by coupling a lossy buffer mode b with dissipation rate *κ_{b}* to the memory mode a via a four-wave mixing non-linear element - typically a Josephson junction or an ATS -, and by engineering the Hamiltonian $\frac{H}{ℏ} = {g}_{2} \left({a}^{2}-{α}^{2}\right) {b}^{†} + h . c .$, where *b* is the photon annihilation operator of the buffer mode b, *g*₂ is the two-photon coupling rate, and ℏ is the reduced Planck constant.

This Hamiltonian is engineered by applying a two-photon pump at frequency |2*fₐ - f_{b}*| to the four-wave mixing non-linear element, and by driving the buffer mode b at frequency *f_{b},* provided *g*₂ < *κ_{b}.*

Likewise, the Kerr Hamiltonian stabilization, which is performed by combining Kerr nonlinearity and a squeezing drive applied to a superconducting non-linear asymmetric inductive element (SNAIL) at a frequency equal to twice the resonant frequency thereof, also requires electromagnetic radiation sources.

The corresponding Hamiltonian can be expressed as follows: $\frac{H}{ℏ} = - {Ka}^{† 2} {a}^{2} +$ *ε*₂(*a*^{†2} + *a*²), where *K* is the amplitude of the Kerr nonlinearity, *a* is the photon annihilation operator, *ε*₂ is the amplitude of the squeezing drive, and ℏ is the reduced Planck constant.

In light of the above, it appears that the resonator 3 can be controlled and stimulated through two ports: the first port, i.e. the DC source 7, allows selecting the operating point of the resonator 3 by tuning its resonant frequency; and the second port, i.e. the electromagnetic radiation source 11, enables performing spectroscopy or reflection measurements by subjecting the resonator 3 to pulses. In other words, the second port is to be used for probing the response of the resonator 3.

### A.4. Computing and processing components

The memory is configured to store a computer program comprising instructions whose execution, by the processing unit, causes the multi-modal measurement device 1 to compute the respective value of one or more parameters. These parameters, such as flux noise, line attenuation, line temperature, and quantum efficiency, will be discussed hereinafter.

The memory can also be configured to store data acquired by the multi-modal measurement device 1.

The memory can be any computer-readable storage medium capable of receiving and storing data. Such a computer-readable storage medium can a be a transitory or a non-transitory medium. The memory can be a hard disk drive (HDD), a flash memory - such as a solid-state drive (SSD) or a Secure Digital (SD) card -, a random access memory (RAM), an optical disc, a magneto-optical drive, or a solid-state hybrid drive (SSHD), for instance. A combination of several types of computer-readable storage media can also be envisaged.

The processing unit is configured to execute the instructions stored in the memory for computing the respective value of one or more parameters based on data acquired by the multi-modal measurement device 1.

The processing unit can be a microprocessor, a programmable logic device (PLD) - such as a field-programmable gate array (FPGA) or a complex programmable logic device (CPLD) -, an application-specific integrated circuit (ASIC), or a microcontroller.

A combination of several types of processors can also be envisaged.

As explained below, the processing unit is used to determine the values of physical parameters based on measurements performed using the multi-modal measurement device 1.

### B. Flux noise measurement

As previously explained, the resonant frequency of the resonator 3 can be tuned by varying the inductance of the inductive element 15. To achieve this, the intensity of the electric current supplied by the DC source 7 to the flux line 5 is adjusted to modify the magnetic flux through the inductive element 15.

The resonant frequency of the resonator 3 therefore depends on the magnetic flux through the inductive element 15.

The relationship between the intensity of the electric current and the induced magnetic flux through the inductive element 15 is the following: ${Φ}_{DC} = M ⋅ {I}_{DC}$ where: - Φ*_{DC}* is the magnetic flux through the inductive element 15 induced by the electric current,
- *M* is the mutual inductance between the flux line 5 and the inductive element 15, and
- *I_{DC}* is the intensity of the electric current supplied by the DC source 7.

By adjusting the intensity *I_{DC},* the magnetic flux Φ*_{DC}* can be precisely controlled to set the resonator 3 at a desired operating point.

However, in addition to the controlled magnetic flux Φ*_{DC}* induced by the DC source 7, the inductance of the inductive element 15 further depends on an undesired and uncontrolled noise, known as flux noise. The flux noise perturbs the effective inductance of the inductive element 15, leading to fluctuations in the resonant frequency of the resonator 3.

To measure flux noise, the multi-modal measurement device 1 can be used to track variations in the resonant frequency of the resonator 3 These variations provide direct information about fluctuations in the total magnetic flux Φₑₓₜ, which corresponds to the combination of the controlled magnetic flux Φ*_{DC}* induced by the DC source 7 and the flux noise.

More precisely, a small frequency shift *δf* can be related to a small change in magnetic flux *δ*Φₑₓₜ by the following formula: $δf = \frac{df}{d {Φ}_{ext}} δ {Φ}_{ext}$

The term $\frac{df}{d {Φ}_{ext}}$ represents the sensitivity of the resonant frequency of the resonator 3 to changes in magnetic flux and can be determined experimentally. This is achieved by sweeping the intensity *I_{DC}* of the electric current supplied by the DC source 7 around the working point while simultaneously measuring the resonant frequency of the resonator 3.

Indeed, the sensitivity $\frac{df}{d {Φ}_{ext}}$ of the resonant frequency of the resonator 3 to changes in the magnetic flux can be related to the sensitivity $\frac{df}{{dI}_{DC}}$ of the frequency to changes in the intensity *I_{DC}* of the electric current through the following chain rule: $\frac{df}{d {Φ}_{ext}} = \frac{df}{{dI}_{DC}} ⋅ \frac{{dI}_{DC}}{d {Φ}_{ext}}$

Then: $\frac{df}{d {Φ}_{ext}} = \frac{1}{M} ⋅ \frac{df}{{dI}_{DC}}$

This approach allows for the characterization of flux noise in superconducting circuits with high sensitivity, leveraging the frequency response of the resonator 3.

The value of the mutual inductance *M* can be determined. To achieve this, the magnetic flux Φₑₓₜ must be swept over a full period of the frequency response of the resonator 3. Indeed, the use of flux-sensitive devices, such as the DC SQUIDs 17, provides the inductive element 15 - and consequently the resonator 3 - with flux-periodic physical properties. The physical properties of the resonator 3 therefore remain the same for a magnetic flux Φₑₓₜ as for a magnetic flux Φₑₓₜ *+ k* * Φ₀, where *k* is an integer and Φ₀ is the flux quantum, which is a physical constant defined as follows ${Φ}_{0} = \frac{h}{2 e}$*,* where *h* is the Planck constant and e is the elementary charge.

Consequently, when the physical properties of the resonator 3 are identical for two distinct electric currents, the difference in intensity between these two electric currents, multiplied by the mutual inductance *M*, is a multiple of the flux quantum *Φ*₀.

To acquire the most relevant data for measuring flux noise, it is advantageous to select an operating point for the resonator 3 where fluctuations in the magnetic flux have the strongest impact on its resonant frequency.

To achieve this, it is firstly necessary to determine how the resonant frequency of the resonator 3 evolves as a function of the magnetic flux induced by the DC source 7 or, equivalently, as a function of the electric current supplied by the DC source 7 to the flux line 5.

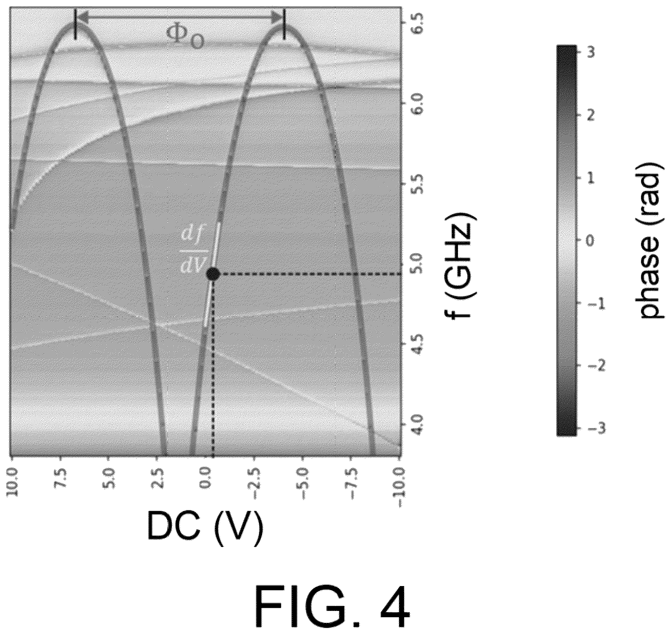

Figure 4 illustrates this evolution. Specifically, Figure 4 shows the flux tunability of the resonator 3. The x-axis represents the voltage applied by the DC source 7 in volts (V), while the y-axis represents the resonant frequency of the resonator 3 in gigahertz (GHz).

Figure 4 is obtained by spectroscopy: a given voltage is applied to the flux line 5, and a signal - or tone -, is sent by the electromagnetic radiation source 11 at a given frequency through the transmission line 9 to the resonator 3 since, as explained above, the transmission line 9 is capacitively coupled to the resonator 3. The response of the resonator 3, i.e. the phase of the reflected signal, is measured. This operation is repeated by sweeping both a voltage range for the DC source 7 and a frequency range for the signal sent through the transmission line 9.

The resonance of the signal and the resonator 3 results in a phase drop. The resonant frequency of the resonator 3 can therefore be obtained in Figure 4 for a given voltage of the flux line 5 by drawing a horizontal line from this given voltage to the phase drop. The resonant frequency of the resonator 3 is the abscissa of the point corresponding to the phase drop.

For this reason, i.e. the implementation of spectroscopy, Figure 4 is associated with a phase scale in radians (rad). The curve representing the evolution of the resonant frequency of the resonator 3 as a function of the voltage applied to the flux line 5 actually corresponds to the set of points where a phase jump was observed during the spectroscopy.

From this curve, it is possible to extract the derivative $\frac{df}{dV}$ that quantifies the extent to which the resonant frequency of the resonator 3 is affected by a magnetic flux perturbation.

Advantageously, the operating point of the resonator 3 to select is in the vicinity of the operating point where the derivative reaches its maximum absolute value. In Figure 4, one of these operating points is shown: it is reached for a slightly positive voltage and corresponds to a resonant frequency of approximately 5 GHz.

As explained above, the physical properties of the resonator 3 are flux-periodic. The period, which corresponds to the flux quantum *Φ*₀, is visible in Figure 4.

Due to the anharmonicity of the resonator 3, the operating point to be selected is not necessarily the one where the derivative is maximal in absolute value, as the anharmonicity varies with the derivative. It is sufficient to select an operating point where the derivative is substantially maximal in absolute value.

Once at this chosen operating point, the frequency response of the resonator 3 is measured. Again, spectroscopy can be used. Multiple signals, each having a respective frequency, are successively delivered by the electromagnetic radiation source 11 to the resonator 3 via the transmission line 9. The response of the resonator 3 is then measured. Specifically, the real (or in-phase I) part and the imaginary (or quadratic Q) part are recorded. Each response of the resonator 3 can thus be represented by a point in a complex plane.

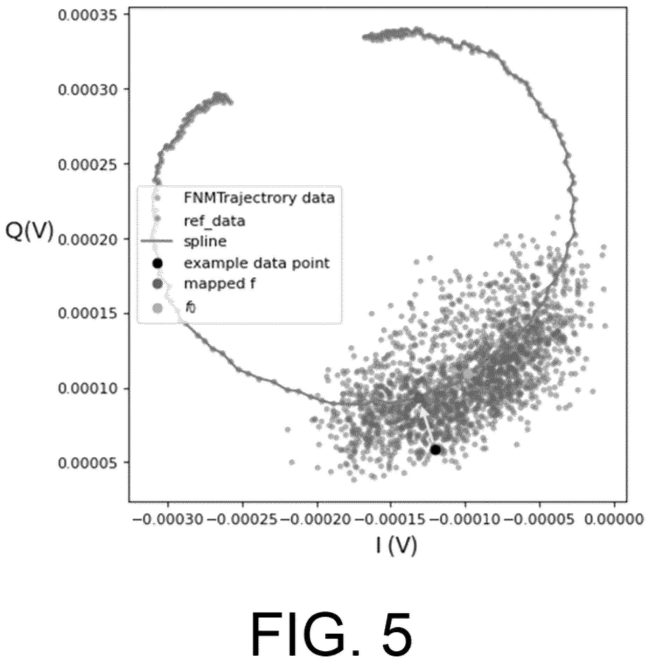

Such a complex plane is illustrated in Figure 5.

Figure 5 shows the measurement points each corresponding to a respective response of the resonator 3 to a signal having a respective frequency. In other words, each measurement point can be associated with a response of the resonator 3, and therefore with a specific frequency. Interpolating these points reveals a curve that is substantially circular in the complex plane.

The frequency corresponding to a measurement point is a *drive* frequency, i.e. the frequency of a signal delivered by the electromagnetic radiation source 11. However, the frequency corresponding to a measurement point can also be assimilated to a resonant frequency of the resonator 3, assuming that the drive frequency remains constant.

Once this circular curve is obtained, for example through interpolation, the frequency of the electromagnetic radiation source 11 is set, and the response of the resonator 3 is measured over a sufficiently long integration time to collect several new measurement points. The new measurement points all thus correspond to the same drive frequency. In Figure 5, these measurements points form a point cloud.

In the absence of flux noise, these measurement points would be located according a gaussian distribution whose center would lie on the circular curve shown in Figure 5. However, the presence of flux noise disturbs the magnetic flux, thereby varying the resonant frequency of the resonator 3. As a result, from one instant to the next, the response of the resonator 3 to two signals having the same drive frequency will be different.

For each measurement point of the point cloud, a corresponding point on the circular curve can be computed, for example, by orthogonal projection. As explained above, a point on the circular curve can be associated with a frequency.

Figure 4, discussed above, makes it possible to associate a magnetic flux value with each frequency. Therefore, the point cloud of Figure 5 can be used to trace the fluctuations of the magnetic flux over time. In other words, the point cloud can be considered as a time evolution of the magnetic flux fluctuations caused by flux noise.

Flux noise can then be computed, for example, by determining the power spectral density from the magnetic flux values corresponding to the measurement points of the point cloud.

The explanations above detail the steps of data extraction using the multi-modal measurement device 1 and the processing applied to the collected data. Typically, such processing to compute flux noise is performed by the processing unit.

### C. Line attenuation measurement

The multi-modal measurement device 1 can operate in multiple modes and therefore measure various parameters. In particular, in addition to flux noise, the multi-modal measurement device 1 can measure the attenuation of the transmission line 9 by leveraging the anharmonicity of the resonator 3.

Specifically, since the resonator 3 is anharmonic, its resonant frequency depends on the occupation of its eigenmode. This property, known as the self-Kerr effect, is characterized by the quantity *K*₄, which represents the magnitude of the frequency shift per photon occupying the eigenmode of the resonator 3.

Furthermore, the number of photons n in the resonator 3 depends on several factors, including the detuning Δ of the electromagnetic radiation *drive* - for example a microwave drive - from the eigenfrequency, the self-Kerr *K*₄, the total linewidth *κₜₒₜ* of the resonator 3 - corresponding to the inverse of its energy decay time -, the coupling *κ_{c}* of the resonator 3 to the transmission line 9, and the amplitude of the electromagnetic radiation *drive,* represented by the photon flux amplitude *α*ᵢₙ: $n = \frac{{κ}_{c} {\left|{α}_{in}\right|}^{2}}{{\left(Δ+{K}_{4}n\right)}^{2} + \frac{{κ}_{tot}}{2}}$

Here, the electromagnetic radiation *drive* corresponds to signal delivered by the electromagnetic radiation source 11 to the resonator 3 via the transmission line 9.

In general, the absolute value of the drive amplitude *αᵢₙ* can be written as follows: $\left|{α}_{in}\right| = μa$ where: - *a* is the amplitude of the electromagnetic radiation drive generated at room temperature, and
- *µ* is an unknown proportionality constant known as the line attenuation.

The measurement of line attenuation is important because it allows for predicting how the transmission line 9 will attenuate the amplitude of a electromagnetic radiation drive, i.e. a signal sent from the electromagnetic radiation source 11 into the cryostat setup.

The difficulty is that, in the two previous equations, all the parameters are unknown, except for the initial amplitude *a* of the electromagnetic radiation drive.

One possible solution is to perform reflection measurements using the multi-modal measurement device 1. A reflection measurement is performed in the same way as spectroscopy, except that it aims to obtain a reflection coefficient S₁₁.

The reflection coefficient S₁₁ can be expressed as follows: ${S}_{11} = 1 - \frac{{κ}_{c}}{- i \left(Δ+{K}_{4}n\right) + \frac{{κ}_{tot}}{2}}$

The measurement of the reflection coefficient S₁₁ can be performed as follows.

First, the amplitude of the electromagnetic radiation source 11 is set.

Then, similar to a spectroscopy measurement, the electromagnetic radiation source 11 sends a series of signals, each with a respective frequency, to the resonator 3 via the transmission line 9.

Each reflected signal, i.e. each signal returning to the same port - the electromagnetic radiation source 11 - is measured, and the corresponding reflection coefficient S₁₁ is extracted. Specifically, the real (or in-phase I) part and the imaginary (or quadrature Q) part of the reflection coefficient S₁₁ are recorded. Each measured reflection coefficient S₁₁ can thus be represented by a point in a complex plane.

By varying the frequency from one signal to the next, multiple measurement points are obtained for a fixed amplitude value. Once all reflection measurements for a given amplitude value have been completed, the amplitude of the electromagnetic radiation source 11 is varied, and a new series of reflection measurements, each corresponding to a respective frequency, is performed.

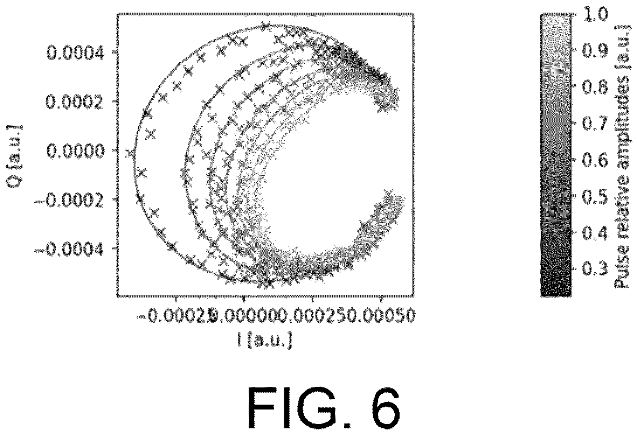

Figure 6 shows the complex plane. The x-axis represents the real part of the reflection coefficient S₁₁, while the y-axis represents the imaginary part of the reflection coefficient S₁₁.

Furthermore, in Figure 6, the measurement points obtained for a given amplitude are used to fit the two previous equations, corresponding respectively to the number n of photons and the reflection coefficient *S*₁₁. A respective curve can thus be fitted for each amplitude value. In other words, Figure 6 displays as many curves as there are tested amplitude values.

The following phenomenon can be noted: the lower the amplitude, the more circular the curve appears; conversely, the higher the amplitude, the more elliptical the curve.

The reflection measurements are then fitted using an exact solution to the steady-state equations, as outlined in N. Bartolo et al. "Exact steady state of a Kerr resonator with one- and two-photon driving and dissipation: Controllable Wigner-function multimodality and dissipative phase transitions" (Phys. Rev. A 94, 033841, 2016).

By fitting the measured data to the theoretical model, the values of the parameters in the previously mentioned equations can be extracted, including, most importantly, the line attenuation *µ*.

As with flux noise measurements, the fitting process, along with the overall data processing, is typically performed by the processing unit.

### D. Embodiment with transmon and readout resonator

The multi-modal measurement device 1 of the example in Figures 1 and 2 can be used in a flux noise measurement mode and a line attenuation measurement mode, as explained in sections B. and C., respectively.

The multi-modal measurement device 1 can be modified and adapted to perform additional measurements.

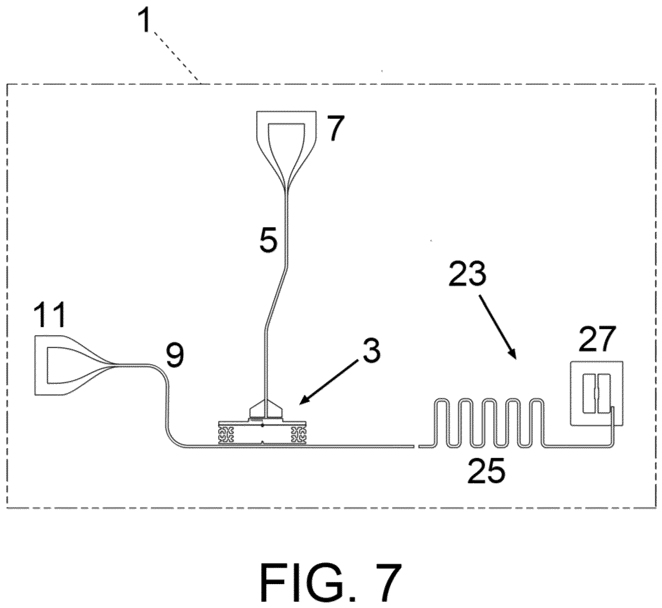

Figure 7 illustrates an embodiment in which the multi-modal measurement device 1 is extended with a measurement circuit 23, which includes a readout resonator 25 and a transmon 27.

In the example of Figure 7, the measurement circuit 23, and more specifically the readout resonator 25, is capacitively coupled to the transmission line 9. Alternatively, the measurement circuit 23 can be inductively coupled to the transmission line 9.

The measurement circuit 23 enables the multi-modal measurement device 1 to perform additional measurements, as detailed below.

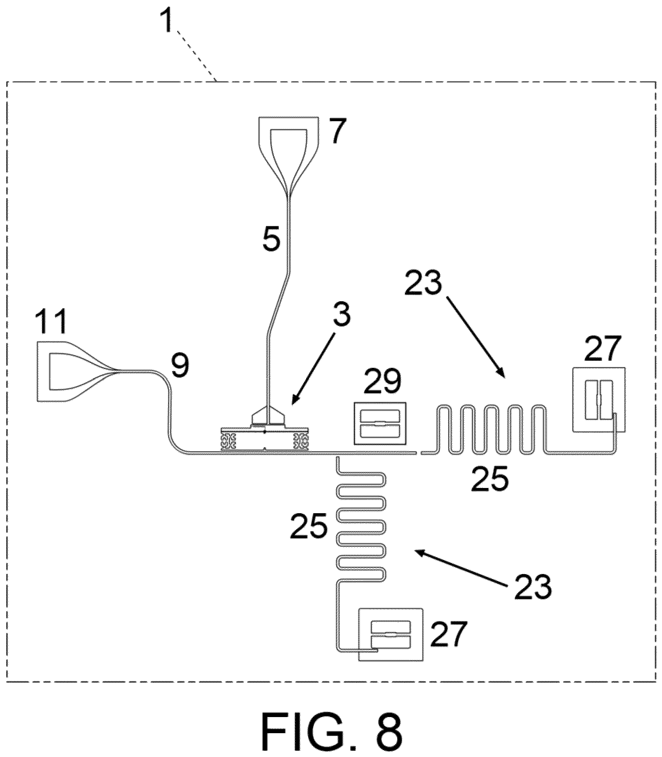

Advantageously, and as illustrated in Figure 8, the multi-modal measurement device 1 can comprise multiple measurement circuits 23. The presence of multiple measurement circuits 23 allows for the parallel execution of several measurements of physical parameters. The multi-modal measurement device 1 can also comprise a transmon 29 capacitively coupled to the transmission line 9.

This configuration make it possible to further measure ionizing radiation or quasi-particles, for example. It is also possible to increase the number of control ports of the multi-modal measurement device 1 and the number of transmission lines 9.

### E. Quantum efficiency measurement

The quantum efficiency *η* of a detector is a measure of its deviation from the ideal limits imposed by quantum mechanics. In superconducting circuits, the detector generally consists of a digitizer preceded by an amplification chain, which measures a microwave pulse that has interacted with a qubit. Through this interaction, information about the qubit state is encoded into the pulse's amplitude and phase, allowing state extraction.

However, this measurement process is intrinsically linked to quantum backaction: as the qubit shares information with propagating photons, it experiences measurement-induced dephasing. The rate of this induced dephasing represents the rate at which information about the qubit is imprinted onto the readout pulse. Ideally, all of this information would be recovered by the amplification chain and digitizer. In reality, noise sources, such as added noise from amplifiers, losses in the transmission line, and inefficiencies in the digitization process, reduce the amount of retrievable information.

Quantum efficiency can be defined as the ratio between the rate of obtainable information and the rate of induced dephasing. A system with perfect quantum efficiency, i.e. *η* = 1, would extract all available information about the qubit state while minimizing excess noise. However, practical limitations generally lower this efficiency.

Determining quantum efficiency is crucial for optimizing quantum measurement schemes, as higher quantum efficiency leads to improved state discrimination and enables faster, high-fidelity qubit readout.

The multi-modal measurement device 1 in Figure 7 can be used to measure quantum efficiency.

The quantum efficiency can be determined from two parameters: coherence and signal-to-noise ratio. Therefore, the multi-modal measurement device 1 is used in a first experiment dedicated to measuring coherence, and in a second experiment dedicated to measuring the signal-to-noise ratio. The first and second experiments are described below.

### E.1. First experiment - Coherence measurement

The first experiment consists of several sub-experiments.

Each sub-experiment is associated with a value of the amplitude of the electromagnetic radiation source 11. In other words, a coherence value is calculated at the end of each sub-experiment, and this coherence value is associated with a corresponding amplitude value of the electromagnetic radiation source 11.

A sub-experiment is implemented within a Ramsey sequence. The Ramsey sequence involves applying two pulses to the transmon 27. The two pulses are separated by a time interval called the "Ramsey time". Each pulse is emitted by the electromagnetic radiation source 11 at the resonant frequency of the transmon 27. Furthermore, each pulse is a π/2-pulse. In other words, each pulse rotates the state vector of the transmon 27 by an angle of π/2 around an axis of the Bloch sphere. More specifically, both the first and second pulses rotate the state vector of the transmon 27 around the Y-axis of the Bloch sphere. The X-axis of the Bloch sphere is the axis on which the coherence is measured.

During the Ramsey time, i.e. between the first π/2-pulse and the second π/2-pulse, the electromagnetic radiation source 11 delivers a first electromagnetic radiation via the transmission line 9 at the resonant frequency of the readout resonator 25 to the measurement circuit 23. This first electromagnetic radiation is at the fixed amplitude value, i.e. the amplitude value associated with the current sub-experiment.

After the second π/2-pulse, the electromagnetic radiation source 11 delivers a second electromagnetic radiation via the transmission line 9 at the resonant frequency of the readout resonator 25 to the measurement circuit 23. The readout resonator 25 receives the second electromagnetic radiation, after its interaction with the transmon 27, and measures a quantum state.

Since the transmon 27 can be, after the measurement, in state |0〉 or in state |1〉, it is preferable to repeat the sub-experiment multiple times, for example 1000 times, for the same amplitude value of the electromagnetic radiation source 11.

The processing unit determines the coherence associated with an amplitude value based on the measurements of the corresponding sub-experiment.

Then, as mentioned above, the amplitude value of the electromagnetic radiation source 11 is modified, and a new sub-experiment is implemented for this new amplitude value. More generally, the amplitude of the electromagnetic radiation source 11 is swept to obtain several coherence values, each corresponding to a respective amplitude value.

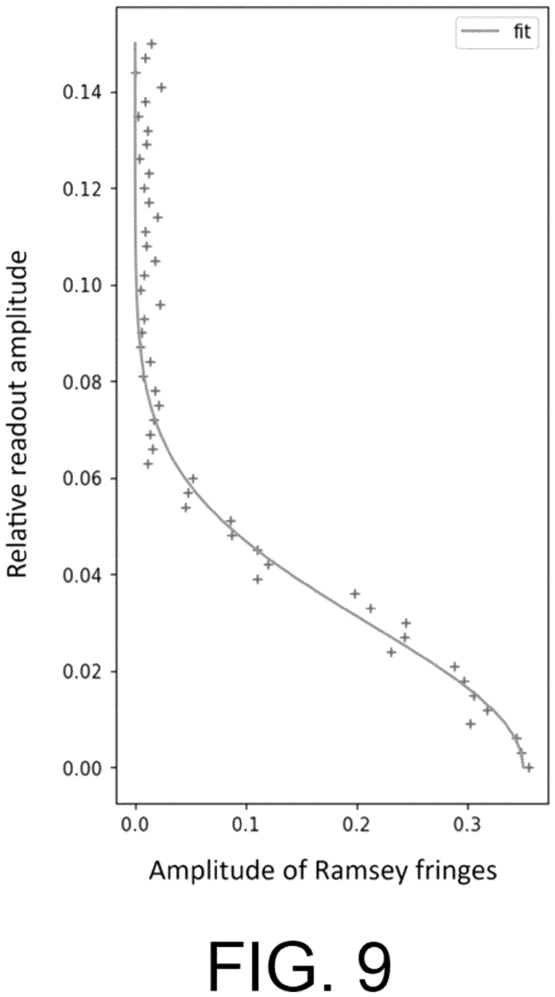

Figure 9 presents a set of coherence measurements. The x-axis represents the amplitude of the Ramsey fringes, while the y-axis corresponds to the amplitude of the electromagnetic radiation source 11.

As expected from theory, coherence |*ρ*₀₁| is observed to be proportional to a quantity of the form ${e}^{- \frac{{ϵ}^{2}}{2 {σ}^{2}}}$, where *σ* is a standard deviation.

By fitting this equation governing the coherence |*ρ*₀₁|, it is possible to extract the standard deviation *σ*.

### E.2. Second experiment - signal-to-noise ratio measurement

The second experiment consists of several sub-experiments.

Each sub-experiment is associated with an amplitude value of the electromagnetic radiation source 11. In other words, a signal-to-noise ratio value is calculated at the end of each sub-experiment, and this signal-to-noise ratio value is associated with the amplitude value of the electromagnetic radiation source 11.

A sub-experiment is implemented with a determined initial state for the transmon 27. For example, this initial state is state 10).

First, the electromagnetic radiation source 11 delivers electromagnetic radiation via the transmission line 9 at the resonant frequency of the readout resonator 25 to the measurement circuit 23. This electromagnetic radiation is at the fixed amplitude value, i.e. the amplitude value associated with the current sub-experiment. The electromagnetic radiation is reflected back to the electromagnetic radiation source 11.

Next, the electromagnetic radiation source 11 delivers a π-pulse at the resonant frequency of the transmon 27. The electromagnetic radiation source 11 then delivers electromagnetic radiation via the transmission line 9 at the resonant frequency of the readout resonator 25 to the measurement circuit 23. This electromagnetic radiation is at the fixed amplitude value, i.e. the amplitude value associated with the current sub-experiment. The electromagnetic radiation is reflected back to the electromagnetic radiation source 11.

Advantageously, as with the first experiment, it is preferable to repeat the sub-experiment multiple times, for example 1000 times, for the same amplitude value of the electromagnetic radiation source 11.

The processing unit determines the signal-to-noise ratio value associated with an amplitude value based on the measurements of the corresponding sub-experiment, and more particularly on the reflected electromagnetic radiations corresponding to the same amplitude value.

Then, as mentioned above, the amplitude value of the electromagnetic radiation source 11 is modified, and a new sub-experiment is implemented for this new amplitude value. More generally, the amplitude of the electromagnetic radiation source 11 is swept to obtain several signal-to-noise ratio values, each corresponding to a respective amplitude value.

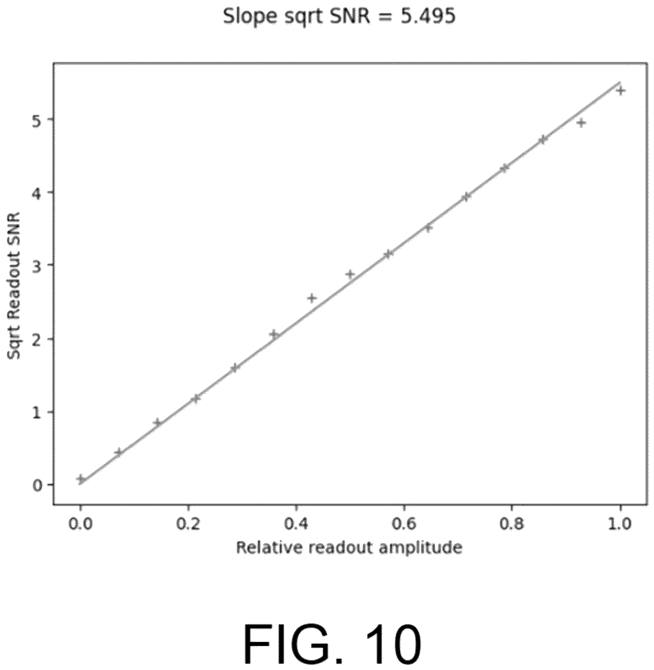

Figure 10 shows signal-to-noise ratio measurements. The x-axis corresponds to the amplitude of the electromagnetic radiation source 11, while the y-axis corresponds to the signal-to-noise ratio.

As predicted by theory, the signal-to-noise ratio SNR is observed to be proportional to the amplitude of the electromagnetic radiation: $SNR = a ϵ$ where: - SNR is the signal-to-noise ratio,
- *a* is a proportionality coefficient, and
- *ε* is the amplitude of the electromagnetic radiation.

By fitting the equation governing the signal-to-noise ratio SNR, it is possible to extract the proportionality coefficient *a*.

The processing unit determines the quantum efficiency *η* based on the proportionality coefficient *a* and the standard deviation as follows: $n = \frac{{σ}^{2} {a}^{2}}{2}$

The method described above is similar to the one developed by C.C. Bultink *et al.*

### F. Another line attenuation measurement

As explained in section C. above, the multi-modal measurement device 1 of Figures 1 and 2 can be used to measure the attenuation of the transmission line 9.

However, the multi-modal measurement device 1 according to the embodiment of Figure 7 or 8 can also be used to measure the attenuation of the transmission line 9 using the measurement circuit 23.

The attenuation of the transmission line 9 is determined by measuring the dephasing rate Γ*_{φ}* of the transmon 27. Dephasing, which is explained in the article J. Gambetta *et al.* (2006), corresponds to the fast decoherence of the superposition of the two lowest energy states of the transmon 27 when it is dispersively coupled to the readout resonator 25.

The dephasing rate Γ*_{φ}* of the transmon 27 can be measured using a Ramsey interference measurement. This measurement is based on the following formula: ${Γ}_{φ} = χ Im \left[{α}_{g}{α}_{e}\right]$ where: - *χ* is the magnitude of the dispersive coupling between the readout resonator 25 and the transmon 27,
- |*α_{g}*〉 is the coherent steady-state within the readout resonator 25 when the transmon 27 is in state |*g*〉, and
- |*αₑ*〉 is the coherent steady-state within the readout resonator 25 when the transmon 27 is in state |e〉.

More specifically, the coherent steady-states |*α_{g}*〉 and |*α_{g}*〉 are obtained when the electromagnetic radiation source 11 continuously drives the readout resonator 25 via the transmission line 9. The amplitude of the electromagnetic radiation drive corresponds to the photon flux amplitude *αᵢₙ* mentioned in section C. above and is detuned from the resonant frequency of the readout resonator 25 by an amount Δ.

As explained in section C. above, the absolute value of the drive amplitude *αᵢₙ* can be written as follows: $\left|{α}_{in}\right| = μa$ where: - *a* is the amplitude of the electromagnetic radiation drive generated at room temperature, and
- *µ* is an unknown proportionality constant known as the line attenuation.

In the line attenuation measurement mode implemented by the multi-modal measurement device 1 of Figure 7 or 8, the dephasing rate Γ*_{φ}* of the transmon 27 is measured by sweeping the amplitude of the electromagnetic radiation drive and varying the detuning, i.e. by sweeping the frequency of the electromagnetic radiation drive.

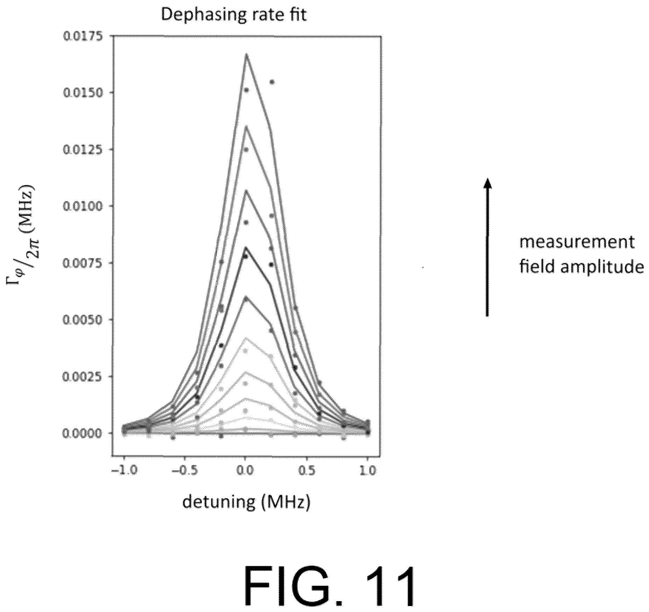

Figure 11 shows the evolution of the dephasing rate Γ*_{φ}* as a function of detuning Δ. The x-axis corresponds to the detuning Δ in MHz, while the y-axis corresponds to the reduced dephasing rate $\frac{{Γ}_{φ}}{2 π}$ in MHz

More specifically, multiple curves are displayed in Figure 11, each corresponding to a different amplitude value of the electromagnetic radiation drive. As the amplitude increases, the peak of the curve becomes higher. In other words, the highest curve corresponds to the highest amplitude value.

It should be noted that for each curve, the peak is reached when the detuning Δ is approximately zero, i.e. when the frequency of the electromagnetic radiation drive is close to the resonant frequency of the readout resonator 25.

The processing unit fits the formula of the dephasing rate Γ*_{φ}* based on the measurements, such as those shown in Figure 11, to determine the attenuation of the transmission line 9.

### G. Line temperature measurement

The temperature of the transmission line 9 can be measured using an anharmonic resonator, which can be the resonator 3, the transmon 27 shown in Figure 7, or indeed another transmon entirely dedicated to the line temperature measurement.

For instance, Figure 8 illustrates an embodiment in which the multi-modal measurement device 1 is extended with a second transmon 29. The transmon 29 may be strongly coupled to the transmission line 9, i.e. more strongly coupled than the other transmon 27. In this embodiment, the second transmon 29 is more strongly capacitively coupled by positioning one of the capacitive pads of the second transmon 27 adjacent - and preferably parallel - to the transmission line 9 so as to include a direct capacitive coupling therebetween.

The second transmon 29 is used to measure the thermal photon occupation of propagating microwave modes through reflection measurements. Operating in the strong coupling regime, where the coupling rate Γ dominates over nonradiative decay (Γₙᵣ) and pure dephasing (*γ_{φ}*), this approach ensures the waveguide's thermal photons govern the scattering dynamics. At resonance, the reflection coefficient r is described as: $r = - 1 + \frac{12 {n}_{r} + \frac{4 {γ}_{φ}}{Γ} + 2 \frac{{Γ}_{nr}}{Γ}}{1 + \frac{Γ}{\left[\left.α\right|\right.} + 4 {\left(\frac{Ω}{Γ}\right)}^{2}}$ where: - *n*ᵣ is the thermal occupation,
- *α* is the resonator anharmonicity, and
- Ω is the Rabi drive rate.

Thermal photons reduce reflectance via incoherent scattering, and the radiation temperature *Tᵣ* is calculated from: ${n}_{r} = \frac{1}{{e}^{\frac{ℏω}{{k}_{b} {T}_{r}}} - 1} .$

The reflection coefficient r can be compared to the reflection coefficient S₁₁ mentioned in section C. above.

In practice, the reflection coefficient is measured as a function of the drive power, which is proportional to Ω². That is, measured data of the reflectance may be plotted against the drive power. When the drive power is very weak, only the constant $r = - 1 + \frac{12 {n}_{r}}{1 + \frac{Γ}{\left[\left.α\right|\right.}}$ remains. Determining the magnitude of the offset of this constant from -1 in the dimension of the reflection coefficient yields the temperature - wherein the physical parameters *α* and Γ are calibrated independently using well-known techniques.

In embodiments, the transmon 27 or the resonator 23 can be used, however it is an advantage of the present design as exemplified in Figure 8 that tailored elements with optimal coupling strengths can be hung from the same transmission line 9 to each independently determine a specific physical parameter, such as flux noise, attenuation line, temperature line, quantum efficiency, as described herein, or indeed quasi-particle detection etc.

## Claims

1. A multi-modal measurement device (1) for measuring physical parameters of a cryogenic environment, comprising:
- a resonator (3) including a capacitive element (13) having a capacitance, and a flux-sensitive inductive element (15) having a variable inductance, said resonator (3) having a tunable resonant frequency depending on said capacitance and variable inductance;
- a flux line (5) inductively coupled to the flux-sensitive inductive element (15);
- a DC source (7) arranged to supply said flux line (5) with electric current for generating a magnetic flux through the flux-sensitive inductive element (15), said magnetic flux varying the inductance of the flux-sensitive inductive element (15);
- a transmission line (9) coupled to the resonator (3);
- an electromagnetic radiation source (11) arranged to deliver electromagnetic radiation via said transmission line (9); and
- a processing unit,
the multi-modal measurement device (1) being configured to operate at least in:
• a flux noise measurement mode in which the DC source (7) supplies the flux line (5) with electrical current for generating a magnetic flux varying the inductance of the flux-sensitive inductive element (15) to tune the resonant frequency of the resonator (3) to reach a desired operating point, the electromagnetic radiation source (11) delivers electromagnetic radiation via the transmission line (9) to the resonator (3) for measuring a time evolution of the resonant frequency of the resonator (3) at said desired operating point, and the processing unit determines flux noise based on said time evolution of the resonant frequency of the resonator (3), and
• at least one other physical parameter measurement mode in which the electromagnetic radiation source (11) delivers electromagnetic radiation via the transmission line (9) to the resonator (3) or another resonator coupled to the transmission line (9) for acquiring a response signal from the resonator (3) or the other resonator, and the processing unit determines said physical parameter based on said signal, the physical parameter being distinct from flux noise.

2. The multi-modal measurement device (1) of claim 1, wherein the capacitive element (13) is a 2D capacitor.

3. The multi-modal measurement device (1) of claim 2, wherein the resonator (3), the flux line (5) and the transmission line (9) are made from a 2D dielectric substrate on which a layer of superconducting material is deposited.

4. The multi-modal measurement device (1) of one of the preceding claims, wherein the capacitance of the capacitive element (13) is less than 1 picofarad.

5. The multi-modal measurement device (1) of one of the preceding claims, wherein the resonator (3) exhibits anharmonicity below 10 MHz, preferably below 1 MHz

6. The multi-modal measurement device (1) of one of the preceding claims, wherein the flux-sensitive inductive element (15) includes one or more DC superconducting quantum interference devices (17), DC SQUIDs, in series, preferably three or more DC SQUIDs in series.

7. The multi-modal measurement device (1) of one of the preceding claims, wherein, in the flux noise measurement mode, the desired operating point is in the vicinity of the operating point at which the derivative of the resonant frequency of the resonator (3) with respect to the magnetic flux is maximal in absolute value.

8. The multi-modal measurement device (1) of one of the preceding claims, wherein, in the flux noise measurement mode, the time evolution of the resonant frequency of the resonator (3) is measured by spectroscopy.

9. The multi-modal measurement device (1) of one of the preceding claims, wherein the multi-modal measurement device (1) is further configured to operate in a line attenuation measurement mode in which the electromagnetic radiation source (11) delivers electromagnetic radiation via the transmission line (9) to the resonator (3) for measuring reflection coefficients of the resonator (3), and the processing unit determines an attenuation value of the transmission line (9) based on said reflection coefficients.

10. The multi-modal measurement device (1) of claim 9, wherein the electromagnetic radiation source (11) is arranged to deliver electromagnetic radiation having controllable amplitude and frequency, and, in the line attenuation measurement mode, the amplitude of the electromagnetic radiation source (11) is successively set to each amplitude value of a set of amplitude values, and, for each of the amplitude values, a plurality of reflection coefficients are measured, each by delivering, from the electromagnetic radiation source (11), electromagnetic radiation having a respective frequency to the resonator (3) via the transmission line (9).

11. The multi-modal measurement device (1) of one of the preceding claims, further comprising a measurement circuit (23) coupled to the transmission line (9), said measurement circuit (23) including a readout resonator (25) and a transmon (27).

12. The multi-modal measurement device (1) of one of the preceding claims, further comprising a transmon (29) capacitively coupled to the transmission line (9).
